# EUROPÄISCHE PATENTANMELDUNG

(11) **EP 0 523 270 A1**
(43) Veröffentlichungstag der Anmeldung: **20.01.1993**
(21) Anmeldenummer: 91112012.9
(22) Anmeldetag: 18.07.1991
(51) Int. Cl.: G05B 19/18, G06F 17/10

(54) **Verfahren zur Steuerung einer Positioniereinrichtung**

(71) Anmelder: International Business Machines Corporation, Armonk, N.Y. 10504 (US)
(72) Erfinder: Dueck, Gunter, W-6903 Neckargemünd (DE); Schauer, Ulrich, W-6920 Sinsheim (DE)
(74) Vertreter: Rach, Werner, Dr.

(57) **Zusammenfassung**

Verfahren zur Steuerung von Positioniereinrichtungen, um zahlreiche in einer Fläche (1) angeordnete Einzelpositionen (2) anzufahren. In einem ersten Schritt erfolgt eine Gruppeneinteilung der Einzelpositionen in der Weise, daß jede Gruppe (10, 13, 14, 15, 16, 17) eine zusammenhängende Teilfläche in der Positionierebene einnimmt. Die Gruppenreihenfolge ist so gewählt, daß die Teilflächen aneinandergrenzen und insgesamt eine geometrische Grobstruktur bilden. In einem zweiten Schritt werden die Einzelpositionen fortlaufend in der Weise indiziert, daß ihre Reihenfolge der geometrischen Grobstruktur folgt. Im letzten Schritt wird die Indizierung der Einzelpositionen abschnittsweise in der Weise verändert, daß der zum sequentiellen Anfahren aller Einzelpositionen eines Abschnitts erforderliche Zeitbedarf minimiert ist.

## Beschreibung

Die Erfindung liegt auf dem Gebiet von technischen Einrichtungen zum Positionieren eines Werkzeugs in Fertigungsprozessen, bei denen eine große Anzahl von Einzelpositionen eines Werkstücks in einer Ebene angefahren werden muß. Ein typisches Beispiel ist die Herstellung von Boards oder Platinen, in die Löcher gestanzt oder gebohrt werden. Dabei befindet sich im allgemeinen das Werkstück auf einem verfahrbaren Positioniertisch und das Werkzeug bzw. die Bearbeitungseinrichtung ist starr angeordnet. Weniger häufig sind die Verhältnisse umgekehrt, d.h. das Werkstück ist fest eingespannt und die Bearbeitungseinrichtung wird über dem Werkstück verfahren. Die Bewegungsmechanik wird im allgemeinen über eine Elektronik oder Prozessoreinrichtung gesteuert.

Es gibt diverse Verfahren zur Steuerung von Positioniereinrichtungen, die sich in ihrer Zielsetzung unterscheiden.

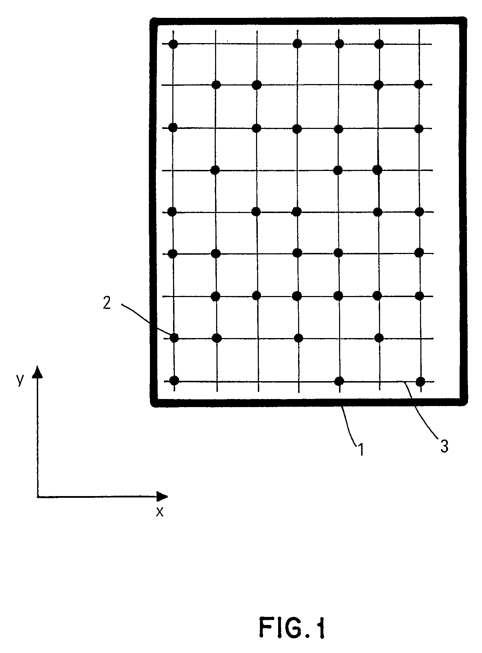

Bei der Bearbeitung von Werkstückoberflächen sind zumeist zahlreiche Einzelpositionen anzufahren. In Figur 1 ist schematisch eine solche Fläche 1 wiedergegeben, auf der sich mehrere Zielpunkte , die anzufahrenden Einzelpositionen 2 befinden. Diese Punkte lassen sich durch ein rechtwinkliges Koordinatensystem X,Y in ihrer Lage definieren. Aus fertigungstechnischen Gründen sind dabei die Einzelpositionen häufig auf einem vorgegebenen Raster 3 angeordnet, aber auch freie Verteilungen sind möglich.

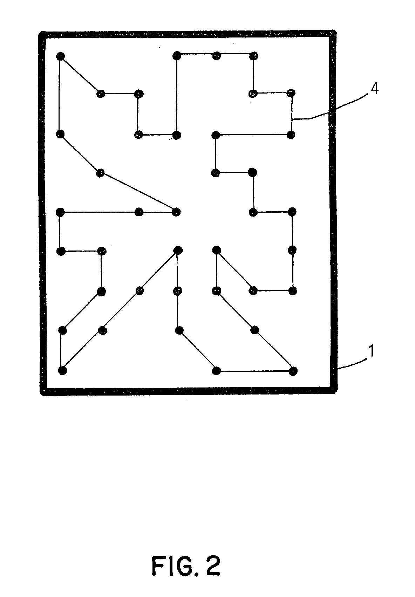

Die Minimierung des erforderlichen Positionierpfads läuft prinzipiell auf die Lösung des "Travelling Salesman Problem" hinaus (weiterhin als TSP bezeichnet). Da eine exakte Berechnung dieses Problems bei einer relativ großen Anzahl (> 100) von anzufahrenden Positionen die Kapazität verfügbarer Rechner übersteigt, sind hier approximative Verfahren entwickelt worden. Für die Minimierung des zur Bearbeitung eines Werkstücks erforderlichen Zeitaufwandes ist als wesentlicher Parameter zusätzlich das Beschleunigungs- und Abbremsverhalten der Positioniermechanik in die TSP Berechnung einzubeziehen. Die als TSP Lösung erhaltenen Positionierpfade sind stark abhängig von der jeweiligen Lage und Anzahl der vorgegebenen Zielpunkte. So führen geringfügige Änderungen des aktuellen Musters, z.B. durch Hinzufügen oder Weglassen einiger weniger Positionen, zu völlig unterschiedlicher Gestalt des jeweiligen Positionierpfads. Ein TSP-Positionierpfad 4 ist schematisch in Figur 2 wiedergegeben.

Auf diese Weise ergeben sich für jeden Werkstücktyp oder Variante spezifische Bewegungsabläufe während des Herstellungsprozesses. Geringe (aber stets vorhandene) Toleranzen der Positioniermechanik wirken sich somit bei jedem Werkstück in unterschiedlicher Weise aus, d.h. toleranzbedingte Positionsabweichungen sind werkstück-individuell. Für eine Fertigung von Werkstücken, bei denen alle Einzelpositionen mit reproduzierbarer Genauigkeit angefahren werden sollen, z.B. bei nacheinander hergestellten einzelnen Lagen von Boards, deren Durchkontaktierungen beim Stapeln exakt aufeinanderliegen müssen, ergibt sich also bei reiner Anwendung der TSP-Lösung ein Präzisionsproblem.

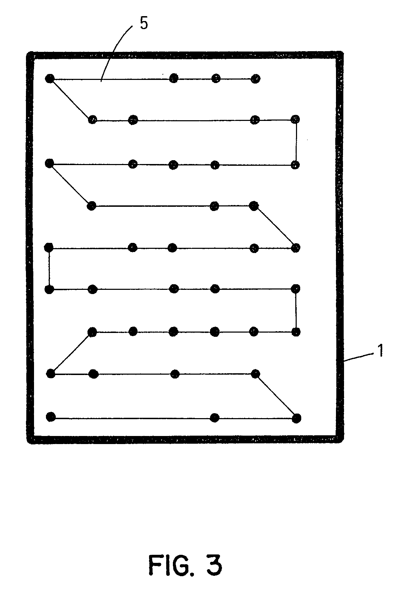

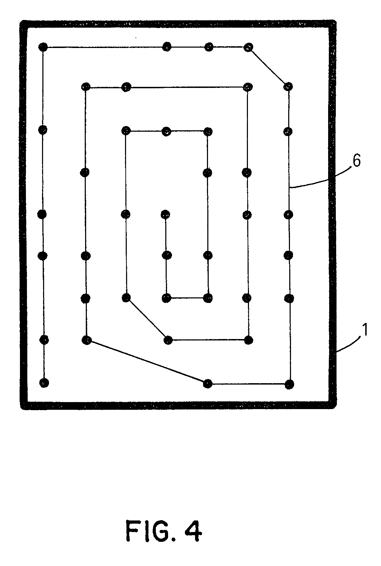

Die gewünschte Genauigkeit kann erreicht werden, indem an Stelle eines TSP-Lösungsweges jedes Werkstück während des Bearbeitungsprozesses nach einem vorgegebenen Schema positioniert wird. Dabei wird unabhängig von individuellen Unterschieden der Werkstücke bezüglich Lage und Anzahl der Einzelpositionen ein definierter Positionierpfad abgefahren. Beispiele hierfür sind mäanderförmige oder spiralförmige Wege 5, 6. Solche Positionierpfade werden in der Technik eingesetzt und sind schematisch in den Figuren 3 und 4 dargestellt. Damit kann eine sehr hohe Präzision reproduzierbar erreicht werden. Nachteilig ist jedoch der hohe Zeitaufwand pro Werkstück aufgrund der sehr langen Positionierpfade.

Der vorliegenden Erfindung liegt die Aufgabe zugrunde, ein Verfahren zur Steuerung einer Positioniereinrichtung zu schaffen, welches geringstmöglichen Zeitbedarf mit hoher und reproduzierbarer Präzision verbindet.

Das erfindungsgemäße Verfahren erreicht dies durch Strukturierung der anzufahrenden Positionen in ein grobes Grundmuster in Kombination mit einer nachgeschalteten Weg-(Zeit)-Optimierung. Dazu ist individuell für jeden Werkstücktyp eine Grobstruktur für den Positionierpfad festgelegt. Des weiteren ist durch eine Weglängen- bzw. Zeitbedarfsminimierung ein Positionierpfad z.B. in Form eines Mäanderwegs innerhalb der Grobstruktur festgelegt. Dabei können mechanische Eigenschaften der Positioniereinrichtung berücksichtigt werden. Der Positionierpfad zeigt aufgrund der vorhandenen Grobstruktur auch für unterschiedliche Werkstücke ein ähnliches Verlaufsmuster. Die erfindungsgemäße Kombination von aufgeprägter Grobstruktur mit überlagerter lokaler Weg-(Zeit)-Optimierung liefert reproduzierbare Präzision bei hoher Positioniergeschwindigkeit.

Weitere Einzelheiten und Vorteile des erfindungsgemäßen Verfahrens werden anhand der folgenden Ausführungsbeispiele unter Bezugnahme auf die Zeichnungen erläutert.
- Figuren 5A-D: zeigen ein Verfahren zur Aufteilung der Grundfläche des Werkstücks in einzelne Abschnitte;
- Fig. 6: zeigt einzelne Mäanderpfade in den verschiedenen Abschnitten;
- Fig. 7: zeigt die spiralförmige Anordnung der durch die Abfolge der Flächenabschnitte gebildeten Grobstruktur;
- Fig. 8: zeigt einen zusammenhängenden Positionierpfad innerhalb der spiralförmigen Grobstruktur der Fig. 7;
- Fig. 9: zeigt einen endgültigen Positionierpfad nach erfolgter Wegoptimierung, wobei jeweils nur wenige Positionen in den einzelnen Optimierungsschritt einbezogen wurden; und
- Fig. 10: zeigt einen endgültigen Positionierpfad nach erfolgter Wegoptimierung, wobei jeweils eine größere Anzahl von Positionen pro Optimierungsschritt berücksichtigt wurden.

In einem ersten Schritt werden alle anzufahrenden Punkte einer Werkstückoberfläche in ein grobes Primär- oder Grundmuster aufgeteilt. Die durch diesen Schritt festgelegte Grobstruktur ist für alle ähnlichen Werkstücke praktisch die gleiche, d.h. unabhängig von individuellen Unterschieden, wie z.B. Anzahl und/oder Lage der Zielpunkte. Der (grobe) Bewegungsablauf beim Anfahren aller Einzelpositionen verläuft daher bei allen Werkstücken analog. Damit ist eine reproduzierbare Präzision gewährleistet, welche der von reinen Mäander- oder Spiralwegen entspricht.

Da häufig der Zeitbedarf für den Positioniervorgang minimiert sein soll, können bei der Bildung der Grobstruktur die geometrischen Längen einzelner Verfahrwege zwischen zwei Positionen entsprechend den Beschleunigungs- und Abbremseigenschaften der Positioniermechanik gewichtet werden. In diesem Fall ist als die 'Länge' eines Wegstücks die zeitliche Dauer, die für das Durchfahren dieses Wegstücks erforderlich ist, zu verstehen.

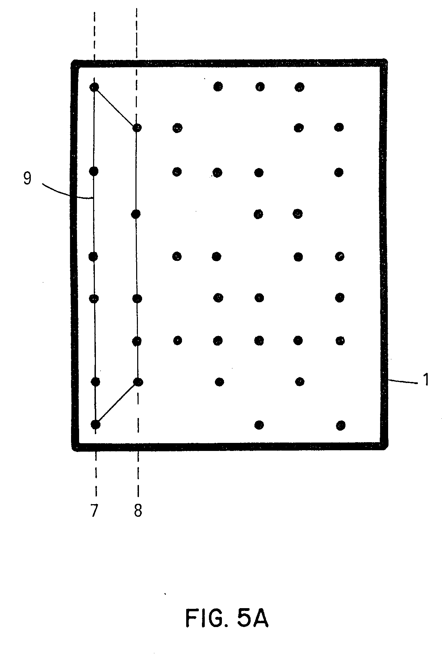

Die Erstellung der Grobstruktur erfolgt durch eine Einteilung der Einzelpositionen in Gruppen, wobei jede Gruppe einen Teil der Werkstückoberfläche einnimmt. Die Abfolge der Gruppen auf der Werkstückoberfläche legt dann die Grobstruktur fest. Figuren 5 A-D demonstrieren das bevorzugte Verfahren. Dabei wird jeweils im Randbereich der noch nicht erfaßten Fläche eine Gruppe durch sukzessives Zuordnen einzelner Zielpunkte zueinander nach den nachfolgenden Auswahlkriterien gebildet. Anschließend wird die nächste Gruppe für einen 90° gedrehten Bereich der Positionierfläche entsprechend gebildet. Auf diese Weise erhält die Abfolge der Gruppen eine spiralförmige Anordnung.

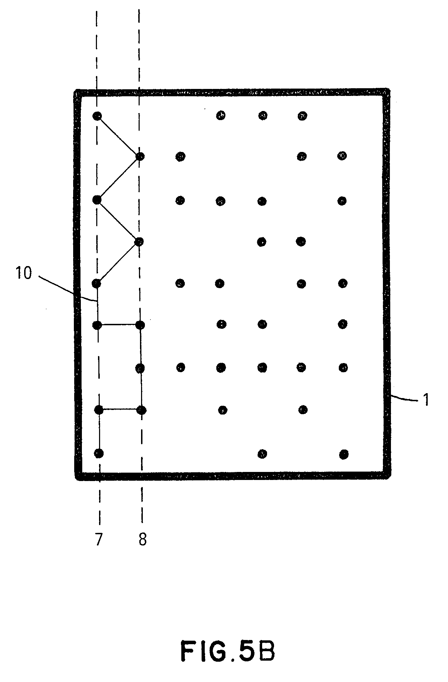

Ausgehend von einer Seite der Werkstückoberfläche werden zunächst alle auf der äußersten Koordinatenlinie 7 befindlichen Punkte zusammen mit den Punkten auf der benachbarten, parallelen Koordinatenlinie 8 zu einem geschlossenen Linienzug 9 miteinander verbunden (Figur 5 A). Die Länge dieses Linienzugs 9 wird verglichen mit der Länge einer mäanderförmigen Verbindungslinie 10 (Figur 5 B) durch die gleichen Punkte. Ein Mäanderweg ergibt sich, indem von einem Punkt aus stets vorrangig zunächst alle in gleicher Höhe befindlichen (d.h. auf einer querverlaufenden Koordinatenlinie liegenden) Punkte angefahren werden. Vom Endpunkt des so erhaltenen, querverlaufenden Linienstücks wird der nächstliegende Punkt auf einer benachbarten querverlaufenden Koordinatenlinie angesteuert. Falls auf dieser Linie mehrere Punkte vorhanden sind, die ebenfalls ein querverlaufendes Linienstück bilden, so wird der entsprechende Endpunkt mit dem kürzesten Abstand angewählt.

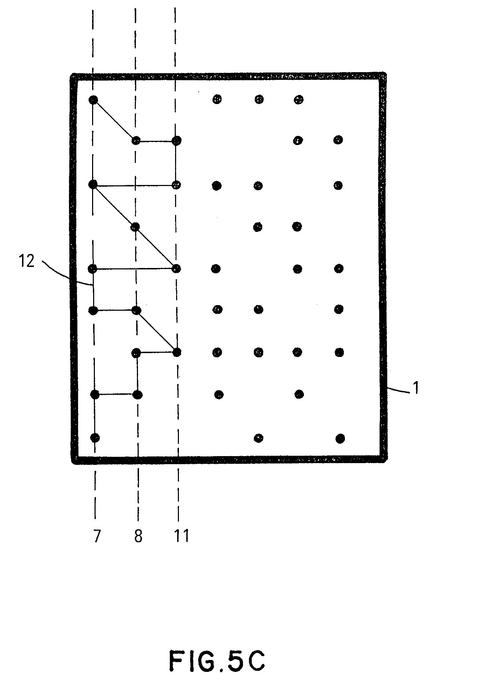

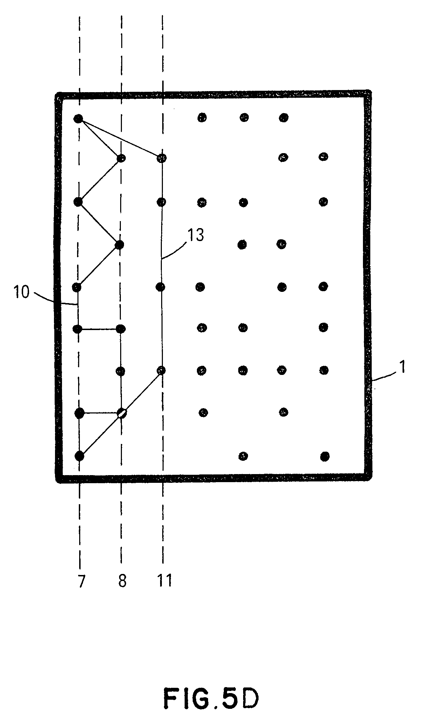

Ist der geschlossene Linienzug 9 kürzer als der Mäanderweg 10, so wird nur die Verbindung der Punkte auf der äußersten Koordinatenlinie 7 als gerader Linienzug beibehalten und das Verfahren nach einer 90° Drehung der Positionierfläche auf entsprechende Koordinatenlinien erneut angewendet. Ist der Mäanderweg 10 kürzer, so wird eine weitere Koordinatenlinie 11 einbezogen (Figur 5 C). Der neue Mäanderweg 12 wird nun wieder verglichen mit dem entsprechenden geschlossenen Weg 13, gebildet aus dem bisherigen Mäanderweg 10 und der linearen Verbindung der neuen Punkte auf der hinzugekommenen Koordinatenlinie 11 (Figur 5 D).

Das Ergebnis des Weglängenvergleichs bestimmt wieder, ob die Punkte auf einer weiteren parallelen Koordinatenlinie einbezogen werden oder das Verfahren nach einer 90° Drehung für einen neuen Abschnitt durchgeführt wird.

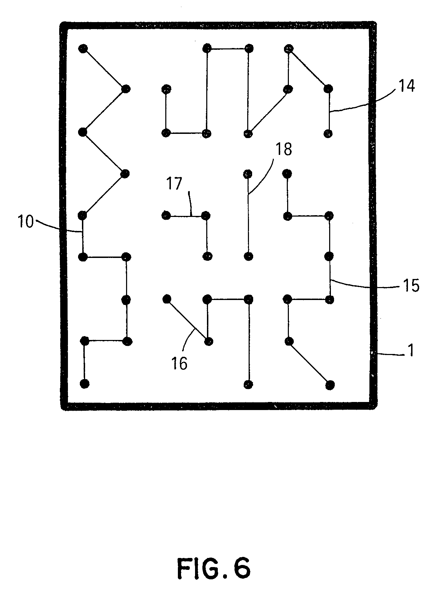

Auf diese Weise entstehen einzelne Linienzüge 10, 14, 15, 16, 17, 18 oder unterschiedlich 'breite' Mäanderwege wie in Figur 6 dargestellt. (Bei dem in der Figur 6 wiedergegebenen Beispiel wurden die Linienzüge willkürlich festgelegt.)

Beim Längenvergleich zwischen Mäander- und geschlossenem Weg kann ein Akzeptanzwert (z.B. 95 % des geschlossenen Wegs) vorgegeben werden, ab dem ein Mäanderweg als Pfad übernommen wird. Durch Veränderung des Akzeptanzwertes läßt sich die durchschnittliche Mäanderbreite steuern, d.h. falls im Vergleich zum geschlossenen Weg nur wesentlich kürzere Mäanderwege akzeptiert werden, so führt dies eher zum Abbruch. Weitere Punkte auf benachbarten Koordinatenlinien werden nicht einbezogen und die Mäanderbreite nimmt nicht mehr zu. Umgekehrt können bei einem weniger strengen Akzeptanzwert sehr breite Mäander entstehen. Als Extremal-Strukturen können so ein reiner Mäander (Figur 3) oder eine Spirale (Figur 4) als flächendeckender Linienzug erhalten werden.

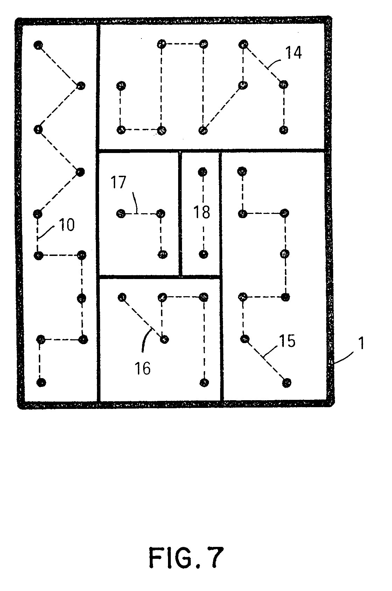

Die Fläche 1 ist nach Durchführung des ersten Verfahrensschritts in mehrere Rechtecke gegliedert, die als Folge aneinandergesetzt eine Spiralstruktur bilden. Dies ist in Figur 7 dargestellt.

Die so definierte Grobstruktur dient als Vorgabe für einen vorläufigen Positionierpfad, der in einem Folgeschritt zu erstellen ist.

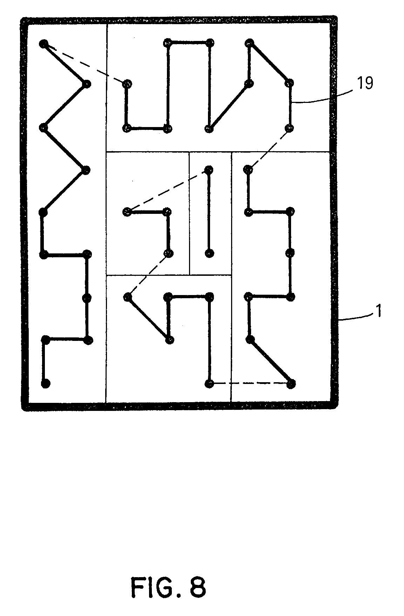

Der vorläufige Positionierpfad 19 wird erzeugt, indem zunächst in jedem Abschnitt (Rechtecke in Figur 7) der Grobstruktur durch Verbindung von Einzelpositionen einzelne, z.B. mäanderförmige Pfadstücke angelegt und mit den jeweiligen Anschlusspfaden der Nachbarabschnitte verbunden werden, wie in Figur 8 dargestellt. Bei der Ausbildung der Grobstruktur nach dem oben beschriebenen bevorzugten Verfahren ist ein entsprechender mäanderförmiger Pfad bereits angelegt. Der so erhaltene Pfad liefert zwar bereits aufgrund der inhärenten Grobstruktur hohe und reproduzierbare Positioniergenauigkeit, ist jedoch in seiner Länge nicht optimiert.

Da häufig nicht die reine Weglänge, sondern der Zeitbedarf der Positionierung minimiert sein soll, können auch für den folgenden Optimierungsschritt einzelne Verfahrwege zwischen zwei Positionen entsprechend den Beschleunigungs- und Abbremseigenschaften der Positioniermechanik gewichtet werden.

Im letzten Schritt des erfindungsgemäßen Verfahrens wird nun eine Weglängenreduktion (respektive Zeitbedarfsreduktion) unter Berücksichtigung der Grobstruktur durchgeführt. Dabei werden kleinere Pfadabschnitte (z.B. in Gruppen von ca. 10 Einzelpositionen) neu gestaltet und durch fortlaufendes Inkrementieren letztendlich sukzessiv die gesamte Pfadlänge (wahlweise unter o.a. Berücksichtigung des durch Beschleunigung und Abbremsung erforderlichen Zeitbedarfs) minimiert. Hierzu können prinzipiell entsprechend angepaßte TSP-Lösungsverfahren angewendet werden. Das bevorzugte Verfahren wendet das Threshold-Accepting-Verfahren an (nach G. Dueck und T. Schauer, in 'Journal of Computational Physics', Vol. 90, No. 1, Sept. 1990, pp. 161-175). Als Ergebnis entsteht ein endgültiger Positionierpfad, der trotz aufgeprägter Grobstruktur eine - wahlweise zeitlich optimierte - Gesamtlänge besitzt, die nur unwesentlich (typisch einige Prozent) unter der einer reinen TSP-Lösung liegt. Im Vergleich zu reinen Mäander- oder Spiralpfaden (Figur 2 oder 3) ist die Wegstrecke - respektive der Zeitbedarf der Positionierung - um durchschnittlich 30 Prozent reduziert.

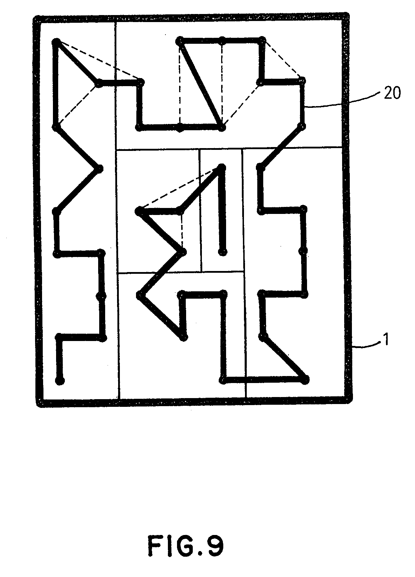

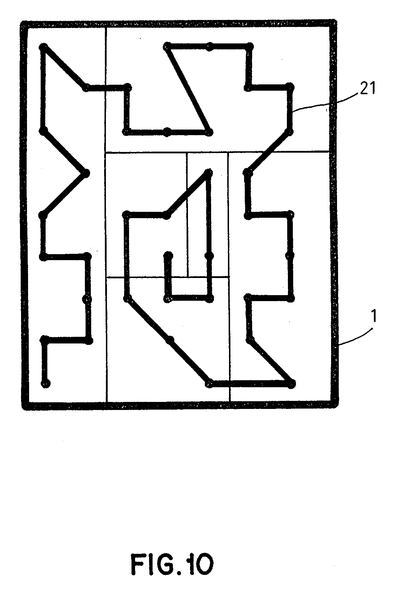

In Figur 9 ist ein optimierter Positionierpfad 20 wiedergegeben, bei dem nur wenige Einzelpositionen pro Pfadabschnitt in die lokale TSP-Wegoptimierung einbezogen wurden, so daß die Grobstruktur in ihrer Ausgangsform erhalten geblieben ist. Durch Vorgabe einer entsprechend großen Anzahl von Einzelpositionen, die im Optimierungsschritt einen Abschnitt bilden, können Details der Grobstruktur zugunsten eines mehr TSP-orientierten Positionierpfads 21 aufgegeben werden (Figur 10). Im Grenzfall ergibt sich bei Einbeziehung aller vorhandenen Positionen ein reiner TSP-Lösungspfad (Figur 4).

Das erfindungsgemäße Verfahren ermöglicht es, daß auch komplexe Positionierpfade mit sehr großer Anzahl von Einzelpositionen ( > einige 1000 ) in kurzer Zeit festgelegt werden können. Insbesondere durch die bevorzugte Untergliederung des Problems der Gesamt-Weglängen- oder Zeitbedarfsreduktion in eine sukzessiv erfolgende Teiloptimierung, bei der jeweils nur relativ wenige Positionen einbezogen werden, kann die optimale Positionierung auch von kleineren Rechner- oder Prozessorsystemen bewältigt werden. Da moderne Positioniereinrichtungen üblicherweise prozessorgesteuert sind, kann mit Hilfe des erfindungsgemäßen Verfahrens eine Optimierung 'in situ' durchgeführt werden, so daß auf Modifizierungen der Werkstücke flexibel im Produktionsbereich reagiert werden kann.

## Patentansprüche

1. Verfahren zur Steuerung einer Positioniereinrichtung, bei dem eine Anzahl in einer Fläche (1) angeordneter Einzelpositionen (2) nacheinander von der Positioniereinrichtung angefahren werden,
dadurch gekennzeichnet,
daß die Fläche (1) abschnittsweise von der Positioniereinrichtung durchfahren wird, wobei
die Abfolge der Flächenabschnitte eine geometrische Grobstruktur und die Reihenfolge der Einzelpositionen innerhalb der Flächenabschnitte eine geometrische Feinstruktur bilden.

2. Verfahren nach Anspruch 1, wobei die geometrische Grobstruktur spiral- oder mäanderförmig ist.

3. Verfahren nach Anspruch 1 oder 2, wobei die die geometrische Feinstruktur bildende Reihenfolge von Einzelpositionen durch eine Weglängenreduktion festgelegt ist.

4. Verfahren nach Anspruch 3, wobei die Reihenfolge der Einzelpositionen abschnittsweise für Gruppen von Einzelpositionen festgelegt ist.

5. Verfahren nach Anspruch 4, wobei durch fortlaufendes Inkrementieren sukzessiv sämtliche Einzelpositionen in ihrer Reihenfolge festgelegt sind.

6. Verfahren nach einem der vorhergehenden Ansprüche, wobei Wegstücke zwischen zwei aufeinanderfolgenden Positionen in der Weise gewichtet sind, daß mechanische Eigenschaften der Positioniereinrichtung einbezogen sind, so daß Weglängen unter dem Aspekt des Zeitbedarfs berücksichtigt werden.

7. Vorrichtung zur Durchführung des Verfahrens nach einem der vorhergehenden Ansprüche, wobei Mittel zur Speicherung eines Positionierpfads (19, 20) vorhanden sind.

8. Vorrichtung zur Durchführung des Verfahrens nach einem der vorhergehenden Ansprüche 1 - 6, wobei Mittel zur Berechnung des Positionierpfads (19, 20) vorhanden sind.
